# EUROPEAN PATENT APPLICATION

(11) **EP 4 428 702 A1**
(43) Date of publication of application: **11.09.2024**
(21) Application number: 22900102.9
(22) Date of filing: 10.10.2022
(51) Int. Cl.: G06F 15/167

(54) **RADIO FREQUENCY CHIP, ALGORITHM RECONSTRUCTION METHOD, AND COMPUTER READABLE STORAGE MEDIUM**

(30) Priority: 30.11.2021 CN 202111449989
(71) Applicant: ZTE Corporation, Shenzhen, Guangdong 518057 (CN)
(72) Inventor: ZHENG, Chuang, Shenzhen, Guangdong 518057 (CN); DAI, Zhengjian, Shenzhen, Guangdong 518057 (CN); WAN, Chao, Shenzhen, Guangdong 518057 (CN); LEI, Jiangli, Shenzhen, Guangdong 518057 (CN); ZHANG, Zuofeng, Shenzhen, Guangdong 518057 (CN)
(74) Representative: Osterhoff, Utz
(86) International application number: PCT/CN2022/124378
(87) International publication number: WO 2023/098295

(57) **Abstract**

The present application relate to the technical field of mobile communication, and in particular to a radio frequency chip, an algorithm reconstruction method and a computer-readable storage medium. The radio frequency chip includes a configuration interface (101), an interconnection bus (102), a processor (104) and at least two operation units (103). Each operation unit is provided with different operation functions. The configuration interface (101) is connected to the processor (104), and is configured to transmit the received routing information and the configuration data to the processor (104). The routing information and the configuration data are determined according to a target operation function of the radio frequency chip. The interconnection bus (102) is communicated with each operation unit (103) and is connected to the processor (104), and is configured to adjust an input and output relationship between each operation unit (103). The operation unit (103) is connected to the processor (104), and is configured to provide a target operation function. The processor (104) is configured to send an instruction for adjusting a routing connection of each operation unit (103) to the interconnection bus, and send allocated configuration data to each operation unit (103).

## Description

### CROSS-REFERENCE TO RELATED APPLICATIONS

The present application claims priority to Chinese patent application No. 202111449989.0, and filed on November 30, 2021, the entire contents of which are incorporated herein by reference.

### TECHNICAL FIELD

Embodiments of the present application relate to the technical field of mobile communication, and in particular to a radio frequency chip, an algorithm reconstruction method and a computer-readable storage medium.

### BACKGROUND

With the continuous development and advancement of the communication technology, the digital predistortion technology applied to the radio frequency chip algorithm is updated and iterated rapidly. For the conventional solution, the field programmable gate array (FPGA) or the dedicated hardware logic circuit on the customized chip is completely used as a direct implementation carrier of the digital predistortion algorithm, to implement specific mathematical operation functions. However, although the programmable function can be provided when the FPGA is used to implement the algorithm function and the algorithm in the later stage can be reprogrammed to meet the needs after a new mathematical operation model is proposed, the energy efficiency of FPGA is low, the operation speed is low, and the power consumption is high, which is gradually unsuitable to be used as a carrier for the radio frequency digital predistortion algorithm. Using a dedicated hardware logic circuit as a direct implementation carrier on a customized chip is more efficient and the operation speed is fast. However, after customized direct implementation, the operation unit only supports fixed operation functions and cannot update the mathematical operation function. After the radio frequency algorithm is updated, the customized chip cannot be compatible with the new algorithm requirements and has insufficient flexibility. Re-developing the chip hardware will cause a waste of manpower, material resources and time.

Although the existing radio frequency chips can perform mathematical operation modification in a certain degree with the support of reconfigurable operation technology, most of the existing operations are based on regular high-density parallel operations, or are designed to be a more general reconfigurable operation. A single operation unit is compatible with a specific mathematical operation function, which still leads to the problem of low hardware resource utilization and low efficiency.

### SUMMARY

The main purpose of the embodiments of the present application is to provide a radio frequency chip, an algorithm reconstruction method and a computer-readable storage medium.

An embodiment of the present application provides a radio frequency chip, including a configuration interface, an interconnection bus, a processor and at least two operation units. Each operation unit is provided with different operation functions; the configuration interface is connected to the processor, and the configuration interface is configured to receive routing information and configuration data and transmit the routing information and the configuration data to the processor; the routing information and the configuration data are determined according to a target operation function of the radio frequency chip; the interconnection bus is communicated with each operation unit and is connected to the processor, and the interconnection bus is configured to adjust an input and output relationship between each operation unit according to an instruction of the processor; the operation unit is connected to the processor, and the operation unit configures the operation function as the target operation function according to the configuration data allocated by the processor; and the processor is configured to send an instruction for adjusting a routing connection mode of each operation unit to the interconnection bus, and send allocated configuration data to each operation unit.

An embodiment of the present application further provides an algorithm reconstruction method, applied to a radio frequency chip. The radio frequency chip includes at least two operation units, and each operation unit is provided with different operation functions. The method includes: obtaining routing information and configuration data through a configuration interface; wherein the routing information and the configuration data are determined according to a target operation function of the radio frequency chip; and adjusting, by an interconnection bus, an input and output relationship between each operation unit according to the routing information, and sending allocated configuration data to each operation unit according to the configuration data for each operation unit to configure the operation function as the target operation function according to received configuration data.

An embodiment of the present application further provides a computer-readable storage medium, storing a computer program0 When the computer program is executed by a processor, the algorithm reconstruction method as mentioned above is implemented.

### BRIEF DESCRIPTION OF THE DRAWINGS

One or more embodiments are exemplified by the pictures in the corresponding drawings, and these illustrative descriptions do not constitute a limitation to the embodiments.
FIG. 1 is a schematic structural diagram of a radio frequency chip according to an embodiment of the present application.
FIG. 2 is a schematic structural diagram of a first operation unit according to an embodiment of the present application.
FIG. 3 is a schematic structural diagram of a second operation unit according to an embodiment of the present application.
FIG. 4 is a schematic diagram of a reconfigurable operation system architecture according to an embodiment of the present application.
FIG. 5 is a flowchart of an algorithm reconstruction method according to another embodiment of the present application.

### DETAILED DESCRIPTION OF THE EMBODIMENTS

It can be seen from the background technology that, although the existing radio frequency chips can perform mathematical operation modification in a certain degree with the support of reconfigurable operation technology, most of the existing operations are based on regular high-density parallel operations, or are designed to be a more general reconfigurable operation. A single operation unit is compatible with a specific mathematical operation function, which still leads to the problem of low hardware resource utilization and low efficiency. Therefore, how to ensure the utilization of hardware resources while ensuring the compatibility and efficiency of radio frequency chips for different algorithm requirements is an urgent problem to be solved.

In order to solve the above problems, embodiments of the present application provide a radio frequency chip including a configuration interface, an interconnection bus, a processor and at least two operation units. Each operation unit is provided with different operation functions, and the configuration interface is connected to the processor. The configuration interface is configured to receive routing information and configuration data, and transmit the routing information and configuration data to the processor. The routing information and configuration data are determined according to the target operation function of the radio frequency chip. The interconnection bus is communicated with each operation unit and is connected to the processor. The interconnection bus is configured to adjust the input and output relationship between each operation unit according to the instructions of the processor. The operation unit is connected to the processor, and the operation unit is used to configure the operation function to the target operation function according to the configuration data allocated by the processor. The processor is configured to send instructions for adjusting a routing connection mode of each operation unit to the interconnection bus, and send allocated configuration data to each operation unit.

After the radio frequency chip in the embodiments of the present application is put into use, the configuration data and the routing information determined by the external software according to the target operation function that the radio frequency chip needs to provide can be received through the configuration interface, and then the processor adjusts the input and output relationships between each operation unit through the interconnection bus according to the routing information. Then the processor will allocate configuration data to the operation units, and configure the operation function of each operation unit as the target operation function, so that the radio frequency chip can configure the compatible operation functions as the target operation function according to actual needs. By obtaining routing information and configuration data generated based on the target operation function, the routing connection methods and operation functions provided by multiple operation units in the radio frequency chip are modified, and each operation unit can provide different operation functions through a software customization manner. Combined with different input and output relationships, the radio frequency chip can meet the algorithm compatibility requirements of multiple algorithms, thereby ensuring the algorithm compatibility of the radio frequency chip while ensuring the high efficiency of hardware processing, and improving the utilization of hardware resources. That is, by flexibly adjusting the operation functions provided by the operation unit in the radio frequency chip and the input and output relationship, the compatibility requirements of new algorithms can be met, and the efficiency of hardware processing can be ensured, thereby improving the utilization of hardware resources.

In order to make the purpose, technical solutions and advantages of the embodiments of the present application clearer, each embodiment of the present application will be described in detail below with reference to the accompanying drawings. However, those skilled in the art can understand that in each embodiment of the present application, many technical details are provided to enable readers to better understand the present application. However, even without these technical details and various changes and modifications based on the following embodiments, the technical solution in the present application can also be implemented. The division of the following embodiments is for the convenience of description and should not constitute any limitation on the specific implementation of the present application. The various embodiments can be combined with each other and quoted from each other on the premise that there is no contradiction.

The implementation details of the radio frequency chip in the present application will be described in detail below with reference to specific embodiments. The following contents are only implementation details for convenience of understanding and are not necessary for implementation of the present application.

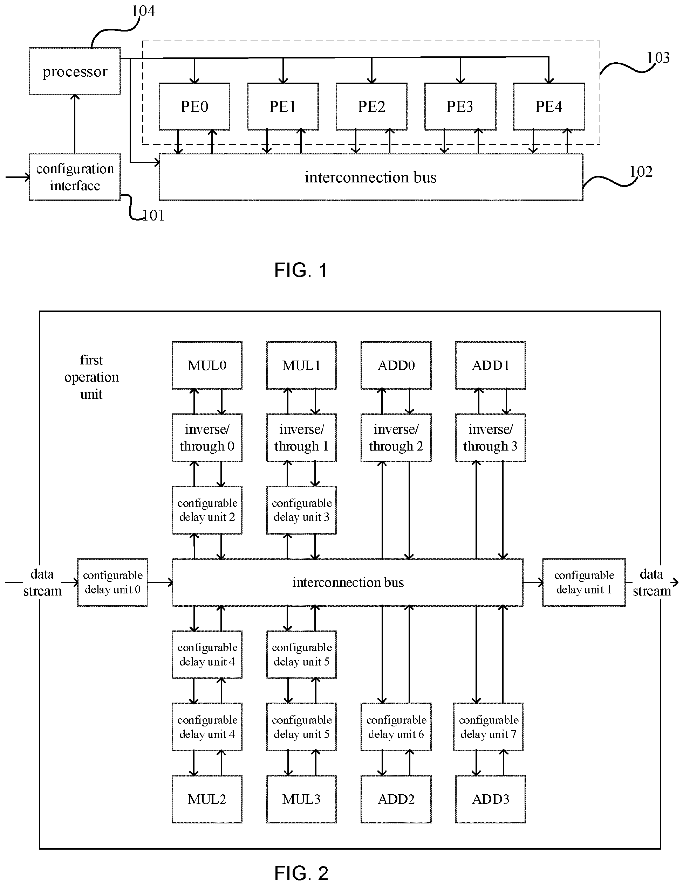

The first aspect of the embodiment of the present application provides a radio frequency chip. The schematic structural diagram of the radio frequency chip can be shown in FIG. 1, which includes:
A configuration interface 101, configured to receive routing information and configuration data.

Specifically, the configuration interface 101 in the radio frequency chip is configured to support communication between the processor 104 and external components or terminals. Therefore, the configuration interface 101 is connected to the processor 104 and is configured to receive routing information and configuration data transmitted from the external components or terminals to the radio frequency chip, and transmit the routing information and configuration data to the processor 104. The routing information and configuration data are determined according to the target operation function of the radio frequency chip.

The interconnection bus 102, configured to adjust the input and output relationships between each operation unit.

Specifically, the interconnection bus 102 is connected to the input terminal and the output terminal of each operation unit, and the initial state is a fully routed state. The interconnection bus 102 is connected to the processor 104. After the radio frequency chip is put into use, the radio frequency chip adjusts the input and output relationship between each operation unit according to the instructions of the processor 104.

It should be noted that the input terminal and the output terminal of the operation unit can be determined according to the input and output relationship with other operation units. When the radio frequency chip provides different operation functions or is connected to different operation units, the input terminal and the output terminal may be the same terminal or different terminals, which will not be limited here.

At least two operation units 103, configured to provide target operation functions.

Specifically, for each operation unit 103 in the radio frequency chip, the operation unit 103 is interconnected with other operation units through the interconnection bus 102 and is connected to the processor 104. After the radio frequency chip is put into use, the operation function is configured as the target operation function according to the configuration data allocated by the processor 104.

For example, the arithmetic unit in the radio frequency chip includes a first operation unit PEO, a second operation unit PE1, a third operation unit PE2, a fourth operation unit PE3 and a fifth operation unit PE4. The first operation unit PE0 and the second operation unit PE1, the third operation unit PE2, the fourth operation unit PE3 and the fifth operation unit PE4 are connected to each other through the interconnection bus.

It should be noted that in some embodiments, one operation unit is connected to all the remaining operation units in the radio frequency chip, while in other embodiments, one operation unit is connected to some operation units in the radio frequency chip, and only different operation functions need to be implemented, which will not be limited in this embodiment.

A processor 104, configured to adjust the algorithm function compatible with the radio frequency chip.

Specifically, the processor 104 is connected to the configuration interface 101, the operation unit 103 and the interconnection bus 102 respectively, and sends instructions for adjusting a routing connection mode of each operation unit 103 to the interconnection bus 102 according to the received configuration data and routing information. The input and output relationships between each operation unit 103 are modified, and the allocated configuration data is sent to each operation unit 103 for each operation unit 103 to configure the operation function as the target operation function, so that the algorithm function compatible with the radio frequency chip is adjusted to the target operation function.

Specifically, after determining the target operation function that the radio frequency chip needs to provide, the external component or the terminal equipment will send the data stream that can transmit routing information and configuration data to the configuration interface 101 of the radio frequency chip through the communication module or the external configuration module. The processor 104 will adjust the input and output relationships between each operation unit 103 through the interconnection bus 102 according to the configuration data and the routing information received through the configuration interface 101. For example, the parallel state or the series state that the multiple operation units 103 are in will be modified, and corresponding configuration parameters are sent to each operation unit 103 for each operation unit 103 to configure the operation function as the target operation function, so that the radio frequency chip can finish the conversion of compatible operation functions and convert the compatible operation function into the target operation function. By obtaining the configuration data and the routing information generated based on the target operation function of the radio frequency chip, the routing connection methods and the provided operation functions of the multiple operation units in the radio frequency chip are modified, and the change of the radio frequency digital predistortion algorithm supported by the radio frequency chip can be achieved with the software customization manner. In this way, not only the hardware resource utilization, the processing speed and the low energy consumption can be ensured, but also the radio frequency chip can flexibly support algorithms. The algorithms that the radio frequency chip can support include but are not limited to a variety of radio frequency digital predistortion algorithms.

In an embodiment, the operation unit in the radio frequency chip includes a first operation unit with an arithmetic operation function, and a second operation unit with a lookup table operation function. By setting up one or more first operation units with arithmetic composite operation functions, and one or more second operation units with lookup table operation functions, it is ensured that when the radio frequency chip modify the supported algorithm according to the software configuration, as many algorithms as possible can be modified to meet as many algorithm requirements as possible, thereby saving the manpower, material, and time costs due to re-developing new radio frequency chips or adding new hardware resources to be compatible with new operation functions.

It should be noted that each first operation unit can support one or more arithmetic operation functions, and each second operation unit can support one or more lookup table operation functions. In specific applications, the appropriate first operation unit and the second operation unit can be selected as needed, which will not be limited in this embodiment.

Furthermore, the interconnection bus is also connected to the internal units of each operation unit, and the interconnection bus is also configured to adjust the input and output relationships between the internal units of each operation unit according to the instructions of the processor. In order to enable the operation unit that is compatible with multiple operation functions to provide specified operation functions, the processor also determines the operation functions provided by each internal unit of each operation unit and the routing connection method between each unit based on the target operation function of each operation unit, and adjusts the input and output relationships between the internal units of each operation unit through the interconnection bus to ensure that each operation unit in the radio frequency chip accurately provides the designated operation function.

It should be noted that the interconnection bus can be directly connected to each operation unit by the connection with the internal units of each operation unit, that is, the operation unit can be directly connected to the interconnection bus through each internal unit connected by the interconnection bus. In this embodiment, the specific connection methods between the operation units, and the internal units of the operation units with the interconnection bus are not limited in this embodiment.

In an embodiment, the first operation unit in the radio frequency chip includes N real number multiplication units, N real number addition units, 2N inverse through units, and (N+2) configurable delay units. N is positive integer. The first operation unit includes a first input terminal and a first output terminal, and each of the first input terminal and the first output terminal is connected to a configurable delay unit. The real number addition unit, the inverse through unit corresponding to the real number addition unit, and the configurable delay unit corresponding to the real number addition unit is connected to the interconnection bus in sequence. The real number multiplication unit, the inverse through unit corresponding to the real number multiplication unit are connected to the interconnection bus in sequence. By setting a corresponding inverse through unit for each real number multiplication unit and each real number addition unit, and setting a configurable delay unit for the real number multiplication unit, the first operation unit can not only perform compound operations of addition and multiplication, but also perform compound operations of subtraction and multiplication, and can provide support for addition and multiplication between complex numbers, thereby expanding the arithmetic operation functions of the first operation unit as much as possible.

Further, the first operation unit in the radio frequency chip includes 4N real number multiplication units, 4N real number addition units, 8N inverse through units, and (4N+2) configurable delay units. N is a positive integer. The first operation unit includes a first input terminal and a first output terminal. Each of the first input terminal and the first output terminal is connected to a configurable delay unit. The real number addition unit, the inverse through unit corresponding to the real number addition unit, and the configurable delay unit corresponding to the real number addition unit are connected to the interconnection bus in sequence. The real number multiplication unit, the inverse through unit corresponding to the real number multiplication unit are connected to the interconnection bus in sequence. The first input terminal and the first output terminal of the first operation unit are respectively connected to a configurable delay unit, and the interconnection bus is respectively connected to the configurable delay unit corresponding to each real number multiplication unit and the inverse through unit corresponding to each real number addition unit. The interconnection bus is configured to adjust the routing connections of each unit inside the first operation unit according to the instructions sent by the processor based on the routing connection information, and send the received data to be processed to the designated real number addition unit and/or the real number multiplication unit. For any real number addition unit, the real number addition unit is connected to the corresponding inverse through unit, and is configured to perform addition operations on the acquired data to be processed according to the received configuration parameters, and output the operation results. For any real number multiplication unit, the real number multiplication unit is connected to the corresponding inverse through unit, and is connected to the corresponding configurable delay unit through the corresponding inverse through unit. The real number multiplication unit is configured to perform addition operations on the acquired data to be processed according to the received configuration parameters and output the operation result. The configurable delay unit is configured to delay the transmission of the received data according to the received configuration parameters. The inverse through unit is configured to invert the obtained data according to the received configuration parameters, and then is configured to transmit or transfer the data directly. By setting the structure of the first operation unit to be in an appropriate form, the first operation unit can support as many arithmetic operation functions as possible according to the external configuration.

A schematic structural diagram of a first operation unit is as shown in FIG. 2, which includes 4 real number adders (ADD0 to ADD3), 4 real number multipliers (MUL0 to MUL3), 8 inverse through units (inverse/through 0 to 7), 6 configurable delay units (configurable delay units 0 to 5) and an internal configurable interconnect routing module. The input terminal of the configurable delay unit 0 is configured to receive the data to be processed, and the output terminal is connected to the interconnection bus. The data output of the interconnection bus respectively passes through the configurable delay unit 2, the configurable delay unit 3, the configurable delay unit 4 and the configurable delay unit 5 corresponding to the configurable delay unit 1 and MUL0 to MUL3, and inverse/through 2, inverse/through 3, inverse/through 6 and inverse/through 7 corresponding to ADD0 to ADD3 respectively. One output terminal of the configurable delay unit 2 corresponding to MUL0 is connected to the internal configurable interconnection routing module, and the other output terminal is connected to the inverter/through 0. One output terminal of the configurable delay unit 3 corresponding to MUL1 is connected to the interconnection bus, and the other output terminal is connected to the inverse/through 1. One output terminal of the configurable delay unit 4 corresponding to MUL2 is connected to the interconnection bus, and the other output terminal is connected to the inverse/through 4. One output terminal of the configurable delay unit 5 corresponding to MUL3 is connected to the interconnection bus, and the other output terminal is connected to the inverse/through 5. One output terminal of the inverse/through 0 is connected to the configurable delay unit 2, and the other output terminal is connected to MUL0. One output terminal of the inverse/through 1 is connected to the configurable delay unit 3, and the other output terminal is connected to MUL1. One output terminal of the inverse/through 2 is connected to the interconnection bus, and the other output terminal is connected to ADD0. One output terminal of the inverse/through 3 is connected to the interconnection bus, and the other output terminal is connected to ADD1. One output terminal of the inverse/through 4 is connected to the configurable delay unit 4, and the other output terminal is connected to MUL2. One output terminal of the inverse/through 5 is connected to the configurable delay unit 5, and the other output terminal is connected to MUL3. One output terminal of the inverse/through 6 is connected to the interconnection bus, and the other output terminal is connected to ADD2. One output terminal of the inverse/through 7 is connected to the interconnection bus, and the other output terminal is connected to ADD3. The output terminal of MUL0 is connected to the inverse/through 0. The output terminal of MUL1 is connected to the inverse/through 1. The output terminal of MUL2 is connected to the inverse/through 4. The output terminal of MUL3 is connected to the inverse/through 5. The output terminal of ADD0 is connected to the inverse/through 2. The output terminal of ADD1 is connected to the inverse/through 3. The output terminal of ADD2 is connected to the inverse/through 6. The output terminal of ADD3 is connected to the inverse/through 7.

During the process that the processor reconfigures the arithmetic operation function provided by the first operation unit in the radio frequency chip, the data stream carrying the configuration parameters is transmitted to MUL0, MUL1, MUL2, MUL3, ADD0, ADD1, ADD2, ADD3, the inverse/through 0, the inverse/through 1, the inverse/through 2, the inverse/through 3, the inverse/through 4, the inverse/through 5, the inverse/through 6, the inverse/through 7, the configurable delay unit 0, the configurable delay unit 1 and the interconnection bus respectively based on the routing information and the configuration data received through the configuration interface. The routing connections of each internal unit of the first operation unit are adjusted through the interconnection bus, and the input and output relationships between each unit are set. The working status of each unit is set through configure parameters, so that the data processing flow and sequence in the first operation unit can meet the needs of the radio frequency signal pre-distortion algorithm to provide the target operation function. During the operation of the radio frequency chip, the data stream to be processed is input to the first operation unit through the configurable delay unit 0. The output terminal of the configurable delay unit 0 is connected to the interconnection bus, and the interconnection bus transmits data to be processed to the adder or the multiplier in a certain processing sequence according to the instructions of the processor. Then the processed operation results is integrated and transmitted to the next node through the configurable delay unit 1.

In addition, the first operation unit including 4 real number multiplication units, 4 real number addition units, 8 inverse through units, and 6 configurable delay units can adjust the operation functions to any of the following operation function according to the received configuration parameters: the complex multiplication operation, the complex multiplication-accumulation operation, the real number multiplication operation, the real number multiplication-accumulation operation, the real number digital filter operation, the complex digital filter operation or the real number multiplication and addition operation. In specific applications, the specific number of units in the first operation unit and the routing connection method of each unit can be adjusted according to the usage scenario or algorithm needs to meet more complex operation functions. The number of units in the first operation unit will not be limited in this embodiment.

Further, the radio frequency chip also includes a front-level input interface. The front-level input interface is connected to the second operation unit and is configured to transmit hardware control data to the second operation unit for the second operation unit to implement the lookup table operation function. The hardware control data includes storage address information of the pre-stored data. By setting the front-end input interface at the radio frequency chip, the second operation unit can receive the hardware control data including the pre-stored data storage address information, thereby accurately realizing the lookup table operation function and improving the efficiency and accuracy of processing.

In another embodiment, the second operation unit in the radio frequency chip includes 3M configurable delay units, M complex multiplication units, M complex addition units, M configurable address generation units, M lookup tables, and one multiplex selection unit. M is a positive integer. The configurable address generation unit includes a second input terminal and a second output terminal. The second input terminal is connected to the configuration interface through a corresponding configurable delay unit, and the second output terminal is connected to the input terminal of the lookup table corresponding to the configured address generation unit. The output terminal of the lookup table is respectively connected to an input terminal of the complex multiplication unit, the complex addition unit and the multiplex selection unit corresponding to the lookup table. The other input terminal of the complex multiplication unit is connected to the configurable delay unit corresponding to the complex multiplication unit, and the output terminal of the complex multiplication unit is connected to the input terminal of the multiplex selection unit. The other input terminal of the complex addition unit is connected to the configurable delay unit corresponding to the complex addition unit, and the output terminal of the complex addition unit is connected to the input terminal of the multiplex selection unit. The output terminal of the multiplex selection unit is connected to the configurable delay unit corresponding to the multiplex selection unit and the interconnection bus in sequence. During the operation of the radio frequency chip, the configurable address generation unit is configured to obtain the address of the target content in the lookup table based on the obtained hardware control data and data to be processed, and send the address to the corresponding lookup table. The lookup table is configured to transmit the stored target content to the corresponding complex multiplication unit, the complex addition unit or the multiplex selection unit according to the obtained configuration parameters and address. The complex multiplication unit is configured to perform multiplication on the obtained target content and the data to be processed according to the received configuration parameters, and transmit the operation result to the multiplex selection unit. The complex addition unit is configured to perform addition on the obtained target content and the data to be processed according to the received configuration parameters, and transmit the operation result to the multiplex selection unit. The multiplex selection unit is configured to selectively output the acquired data. The configurable delay unit is configured to delay the transmission of the received data according to the received configuration parameters. By setting the structure of the second operation unit to be in an appropriate mode, the second operation unit can accurately and efficiently implement as many lookup table operation functions as possible based on configuration data and hardware control data.

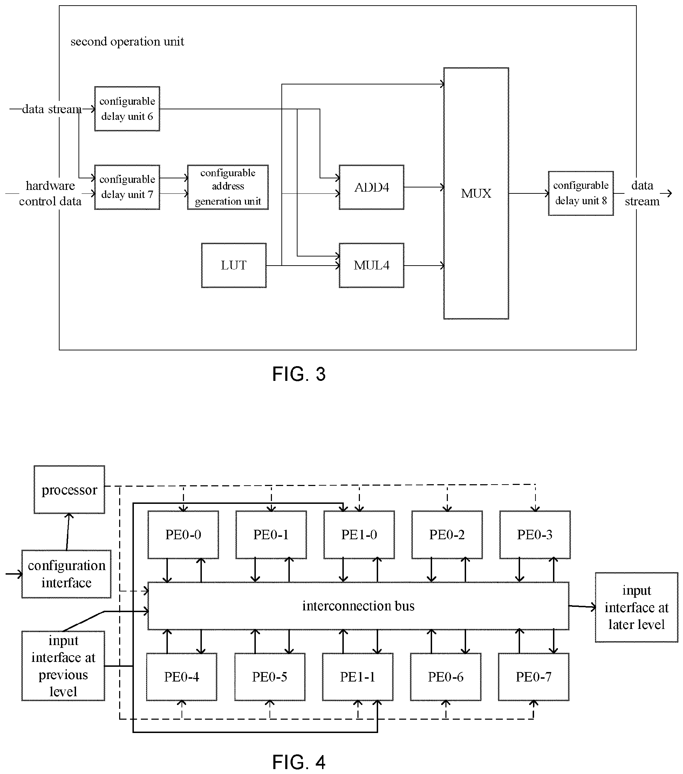

The structural diagram of a second operation unit is as shown in FIG. 3, which includes 3 configurable delay units (configurable delay units 6 to 8), a complex multiplier (MUL4), a complex adder (ADD4), and a configurable address generation unit, a lookup table (LUT), and a multiplexer (MUX). After the processor sends configuration parameters to finish the functional configuration of each unit, the configurable delay unit 6 is configured to receive the data to be processed, and the output terminals are connected to MUL4 and ADD4 respectively to provide data to be processed for MUL4 and ADD4. The input terminal of the configurable delay unit 7 is connected to the front-end input interface and the configuration interface for receiving data to be processed and hardware control data, and the output terminal is connected to the configurable address generation unit. The input terminal of the configurable delay unit 8 is connected to the output terminal of the MUX for delaying the transmission of the operation results. The output terminal of the configurable address generation unit is connected to the lookup table LUT for transmitting the determined address of the target content to the LUT. The output terminals of the lookup table LUT are respectively connected to the input terminals of ADD4, MUL4 and MUX, and are configured to generate the target content to ADD4, MUL4 or MUX. The output terminals of ADD4 and MUL4 are connected to MUX and are configured to provide the calculated target content to MUX. The output terminal of the MUX is connected to the configurable delay unit 8 for selectively outputting the target content and the operation result of the target content.

In the process of modifying the lookup table operation function provided by the second operation unit in the radio frequency chip, the processor transmits the data stream carrying the configuration parameters to the configuration delay unit 6, the configurable delay unit 7, and the configurable delay unit 8, the address generation unit, LUT, ADD4, MUL4, and MUX respectively, so that the input and output relationships between each unit and the working status of each unit can be adjusted. After receiving the hardware control data and the data to be processed, the second operation unit will control the related function F(x, y) through the configurable address generation unit according to the data to be processed and the hardware control stream. x is the data to be processed and y is the address information in the hardware control data. The target content storage address is obtained based on the hardware control data and the data to be processed, and then the obtained address is sent to the lookup table. The lookup table will transmit the target content to the designed ADD4, MUL4 or MUX based on the received address and pre-configured functions. The subsequent unit will perform operations and output on the target content and data to be processed, so that the second operation unit provides the specified lookup table operation function.

In addition, the second operation unit including 3 configurable delay units (configurable delay units 6 to 8), a complex multiplier (MUL4), a complex adder (ADD4), a configurable address generation unit, a lookup table (LUT) and a multiplexer (MUX) can adjust the provided operation function to any of the following operation functions according to the received configuration parameters: the basic lookup table function, the multiplication of lookup table results, and the addition of lookup table results. In the implementation, the specific number of units in the second operation unit can be adjusted according to the usage scenario or algorithm needs to meet the more complex lookup table operation function. The number of units in the second operation unit will not be limited in this embodiment.

In another embodiment, a schematic structural diagram of a radio frequency chip reconfigurable operation system is as shown in FIG. 4, which includes 8 first operation units (PE0-0 to PE0-7) and two second operation units (PE1-0 and PE1-1). The configuration interface is connected to the processor, and the processor is connected to PE0-0, PE0-1, PE0-2, PE0-3, PE0-4, PE0-5, PE0-6, PE0-7, PE1-0, PE1-1, and the interconnection bus of the radio frequency chip respectively. The processor is configured to transmit configuration parameters to each unit and adjust the input and output relationships between units through the interconnection bus. The front-end input interface is connected to the interconnection bus, PE1-0 and PE1-1 respectively, and is configured to transmit data to be processed to the configurable interconnection routing module and transmit hardware control data to PE1-0 and PE1-1. The interconnection bus is connected to each operation unit and the output interface of the subsequent stage respectively, and is configured to provide each operation unit with data to be processed, set the routing connection mode of each unit, and output the integrated operation results according to the instructions of the processor.

In order to facilitate understanding, the implementation of the FIR filter function is taken as an example to explain the configuration process of the above system. The function configuration process includes:
step 1, determining the target operation functions that the radio frequency chip needs to provide based on the working tasks of the radio frequency chip. The target operation function is the FIR filter function. The basic operation processing of the FIR filter function is based on multiplication and addition as well as data delay clap, which requires the multiplication and addition function and the configurable delay unit function of PE0. All the 8 PE0 are connected to each other in series. The connection sequence is PE0-0 to PE0-7. The output of the previous stage PE0 enters the next stage PE0 for delay clap and and addition operations. One input of the adder in the first stage PE0 needs to be configured as 0.

Step 2, determining the routing connection method of each operation unit in the radio frequency chip according to the target operation function. PE0 only performs multiplication, addition and data delay clap processing. It is necessary to configure the routing connection mode of all units inside PE0 to connect the data inputted externally to the input of the multiplier and the adder through the interconnection bus, the configurable delay unit, and the inverse through unit. The output terminal of the multiplier also needs to be connected to an input terminal of the adder through the interconnection bus, the configurable delay unit, and the inverse through unit, and then the output terminal of the adder needs to be connected the external of PE0 through the interconnection bus, the configurable delay unit, and the inverse through unit.

Step 3, configuring the connection method of each operation unit and the routing connection method inside the operation unit into the radio frequency chip. That is, configuring the connection methods between PEs determined in steps 1 and 2 and the connection methods of the underlying multipliers, adders, interconnection buses, configurable delay units, and inverse through units inside the PE into the radio frequency chip.

Step 4, setting the working status of each operation unit in the radio frequency chip. Based on the received routing information and configuration data, the processor configures the filter coefficients required for the filtering operation into the corresponding multipliers inside each PE0, and configures 0 into an input of the adder inside the first-stage PE0. Then the processor configures the delay parameters to the configurable delay unit, and configures the inverse through unit with the through mode.

After the configuration is finished, the current function of the radio frequency chip is the FIR filter function. After obtaining the data stream to be processed, the data stream to be processed can be filtered.

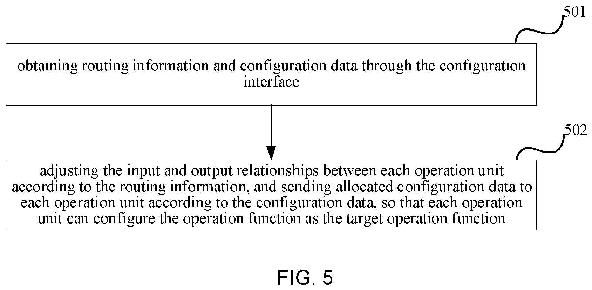

Another aspect of the embodiment of the present application provides an algorithm reconstruction method, which is applied to a radio frequency chip. The radio frequency chip includes at least two operation units, and each operation unit is provided with different operation functions. The flow of the algorithm reconstruction method can be referred to FIG. 5, which includes the following steps:
step 501, obtaining routing information and configuration data through the configuration interface.

Specifically, after the radio frequency chip is put into use, the processor obtains the routing information and configuration data transmitted from the external component or terminals through the configuration interface. The routing information and configuration data are generated by the external component or terminals according to the target operation function that should be provided by the radio frequency chip.

Step 502, adjusting the input and output relationships between each operation unit according to the routing information, and sending allocated configuration data to each operation unit according to the configuration data, so that each operation unit can configure the operation function as the target operation function.

Specifically, after obtaining the routing information and configuration data, the processor determines the input and output relationships between the operation units in the radio frequency chip based on the routing information, and sends instructions for adjusting the routing connections to the interconnection bus, so that the interconnection bus will adjust the input and output relationships between the operation units to the corresponding relationships when the target operation function is achieved. Then the processor sends the allocated configuration parameters to each operation unit based on the operation units to be used and the functions each operation unit needs to provide, so that each operation unit will configure the operation function as the target operation function according to the received configuration parameters. The processor changes the operation function compatible with the radio frequency chip to the target operation function by reconfiguring the routing connection mode and operation function of the operation unit.

Further, the operation unit includes a first operation unit and a second operation unit. The sending the allocated configuration data to each operation unit according to the configuration data includes: sending the allocated first configuration data to the first operation unit for the first operation unit to configure the operation function as the target arithmetic operation function; and/or sending the allocated second configuration data to the second operation unit for the second operation unit to configure the operation function as the target lookup table operation function. In specific applications, the operation unit can also be provided with multiple operation functions, or with operation functions other than arithmetic operation functions and lookup table operation functions. The type and compatible functions of the operation unit can be determined according to specific needs, which will not be limited in this embodiment.

It should be noted that the target arithmetic operation functions of the first operation unit include a complex multiplication operation, a complex multiplication-accumulation operation, a real number multiplication operation, a real number multiplication-accumulation operation, a real number digital filter operation, a complex digital filter operation or a real number multiplication and addition operation. The target lookup table operation functions of the second operation unit include a basic lookup table function, a lookup table result multiplication operation, and a lookup table result addition operation. In specific applications, the first and second units that are compatible with multiple operation functions can be selected as needed, and the number of units in the first and second operation units can be set to achieve various operation functions, which will not be limited in this embodiment.

In an embodiment, the operation unit is provided with a variety of operation functions. When the processor adjusts the input and output relationship between the operation units in the radio frequency chip, the following steps are also included: Adjusting the input and output relationship between the internal units of each operation unit through the interconnection bus. When the operation unit is provided with more than one operation function, in order to update the operation function compatible with the radio frequency chip to the target operation function, the processor not only needs to adjust the input and output relationships between the operation units, but also needs to adjust the input and output relationships between the internal units of the operation unit according to the operation function that each operation unit should provide, so that the radio frequency chip can accurately achieve the target operation function.

In addition, it should be understood that the division of steps in the various methods above is only for the purpose of clear description. During implementation, the steps can be combined into one step or some steps can be divided into multiple steps, and these steps shall all fall within the scope of the present application as long as these steps include the same logical relationship. The added inessential modifications or introduced inessential designs to the algorithm or process but the core design of the algorithm and process is not changed shall all fall within the scope of the present application.

This embodiment is a method embodiment corresponding to the device embodiment, and this embodiment can be implemented in cooperation with the device embodiment. The relevant technical details mentioned in the device embodiment can still be applied to this embodiment, which will not be described for avoidance of repetition. Correspondingly, the relevant technical details mentioned in this embodiment can also be applied to the device embodiment.

Another aspect of the embodiments of the present application also provides a computer-readable storage medium storing a computer program. The above method embodiments are implemented when the computer program is executed by the processor.

Those skilled in the art can understand that all or part of the steps in the methods of the above embodiments can be finished by instructing relevant hardware through a program. The program is stored in a storage medium and includes several instructions to cause a device ( which may be a microcontroller, a chip, and the like) or a processor to execute all or part of the steps of the methods described in various embodiments of the present application. The aforementioned storage medium includes the U disk, the mobile hard disk, the read-only memory (ROM), the random access memory (RAM), the magnetic disk or the optical disk and other medium that can store the program code.

Those skilled in the art can understand that the above-mentioned embodiments are some embodiments for implementing the present application, and during actual applications, various modifications can be made in form and details without departing from the spirit and the scope of the present application.

## Claims

1. A radio frequency chip, **characterized by** comprising a configuration interface, an interconnection bus, a processor and at least two operation units, wherein:
each operation unit is provided with different operation functions;
the configuration interface is connected to the processor, and the configuration interface is configured to receive routing information and configuration data and transmit the routing information and the configuration data to the processor; the routing information and the configuration data are determined according to a target operation function of the radio frequency chip;
the interconnection bus is communicated with each operation unit and is connected to the processor, and the interconnection bus is configured to adjust an input and output relationship between each operation unit according to an instruction of the processor;
the operation unit is connected to the processor, and the operation unit configures the operation function as the target operation function according to the configuration data allocated by the processor; and
the processor is configured to send an instruction for adjusting a routing connection mode of each operation unit to the interconnection bus, and send allocated configuration data to each operation unit.

2. The radio frequency chip according to claim 1, wherein the operation unit comprises a first operation unit with arithmetic operation function and a second operation unit with lookup table operation function.

3. The radio frequency chip according to claim 2, wherein:
the first operation unit comprises N real number multiplication units, N real number addition units, 2N inverse through units, (N+2) configurable delay unit, and N is a positive integer;
the first operation unit comprises a first input terminal and a first output terminal, and each of the first input terminal and the first output terminal is connected to one configurable delay unit respectively;
the real number addition unit, the configurable delay unit corresponding to the real number addition unit, the configurable delay unit corresponding to the real number addition unit are connected to the interconnection bus in sequence; and
the real number multiplication unit, the inverse through unit corresponding to the real number multiplication unit are connected to the interconnection bus in sequence.

4. The radio frequency chip according to claim 3, wherein:
the first operation unit comprises 4N real number multiplication units, 4N real number addition units, 8N inverse through units, (4N+2) configurable delay unit, and N is a positive integer;
the first operation unit comprises the first input terminal and the first output terminal, and each of the first input terminal and the first output terminal is connected to one configurable delay unit respectively;
the real number addition unit, the inverse through unit corresponding to the real number addition unit, the configurable delay unit corresponding to the real number addition unit are connected to the interconnection bus in sequence; and
the real number multiplication unit, the inverse through unit corresponding to the real number multiplication unit are connected to the interconnection bus in sequence.

5. The radio frequency chip according to claim 2, wherein:
the second operation unit comprises 3M configurable delay units, M complex multiplication units, M complex addition units, M configurable address generation units, M lookup tables, and a multiplex selection unit, and M is a positive integer;
the configurable address generation unit comprises a second input terminal and a second output terminal; the second input terminal is connected to the configuration interface through a corresponding configurable delay unit, and the second output terminal is connected to an input terminal of the lookup table corresponding to the configurable address generation unit;
an output terminal of the lookup table is respectively connected to the complex multiplication unit corresponding to the lookup table, the complex addition unit, and an input terminal of the multiplex selection unit;
another input terminal of the complex multiplication unit is connected to the configurable delay unit corresponding to the complex multiplication unit, and an output terminal of the complex multiplication unit is connected to the input terminal of the multiplex selection unit;
another input terminal of the complex addition unit is connected to the configurable delay unit corresponding to the complex addition unit, and an output terminal of the complex addition unit is connected to the input terminal of the multiplex selection unit; and
an output terminal of the multiplex selection unit is respectively connected to the configurable delay unit corresponding to the multiplex selection unit, and the interconnection bus in sequence.

6. The radio frequency chip according to any one of claims 1 to 5, wherein:
the interconnection bus is further communicated with each internal unit of each operation unit, and the interconnection bus is further configured to adjust the input and output relationship between each internal unit of each operation unit according to the instruction of the processor; and
the processor is further configured to send an instruction for adjusting the routing connection mode of each internal unit of each operation unit to the interconnection bus.

7. An algorithm reconstruction method, applied to a radio frequency chip, wherein the radio frequency chip comprises at least two operation units, and each operation unit is provided with different operation functions;
**characterized in that** the method comprises:
obtaining routing information and configuration data through a configuration interface; wherein the routing information and the configuration data are determined according to a target operation function of the radio frequency chip; and
adjusting, by an interconnection bus, an input and output relationship between each operation unit according to the routing information, and sending allocated configuration data to each operation unit according to the configuration data for each operation unit to configure the operation function as the target operation function according to received configuration data.

8. The algorithm reconstruction method according to claim 7, wherein the operation unit comprises a first operation unit and a second operation unit;
the sending the allocated configuration data to each operation unit according to the configuration data comprises:
sending allocated first configuration data to the first operation unit for the first operation unit to configure the operation function as a target arithmetic operation function; and/or
sending the allocated second configuration data to the second operation unit for the second operation unit to configure the operation function as a target lookup table operation function.

9. The algorithm reconstruction method according to claim 7 or 8, further comprising:
adjusting, by the interconnection bus, the input and output relationship between each internal unit of each operation unit.

10. A computer-readable storage medium, storing a computer program, **characterized in that** when the computer program is executed by a processor, the algorithm reconstruction method according to any one of claims 7 to 9 is implemented.
